# EUROPEAN PATENT APPLICATION

(11) **EP 4 280 276 A1**
(43) Date of publication of application: **22.11.2023**
(21) Application number: 22174324.8
(22) Date of filing: 19.05.2022
(51) Int. Cl.: H01L 23/538, H01L 23/31

(54) **AN ELECTRONIC DEVICE MODULE AND A DEVICE MODULE BOTH WITH INCREASED RELIABILITY DUE TO AN ADHESION PROMOTER LAYER**

(71) Applicant: Infineon Technologies Austria AG, 9500 Villach (AT)
(72) Inventor: FUERGUT, Edward, 86453 Dasing (DE); SAX, Harry Walter, 94315 Straubing (DE); SCHMOELZER, Bernd, 9545 Radenthein (AT)
(74) Representative: Lambsdorff & Lange Patentanwälte Partnerschaft mbB

(57) **Abstract**

An electronic device module (10) comprising a core layer (1) comprising an opening (1A), an electronic device (2) disposed in the opening (1A), one or both of the core layer (1) and the electronic device (2) being at least partially covered by an adhesion promoter layer (3), and an encapsulant layer (4) at least partially embedding the core layer (1) and the electronic device (2).

## Description

### TECHNICAL FIELD

The present disclosure is related to an electronic device module, a method for fabricating an electronic device module, a device module, and a method for fabricating a device module.

### BACKGROUND

Over the last couple of years a lot of activities have been carried out concerning the embedding of passive components and active semiconductor dies into PCB or package carrier systems. Some low voltage use cases have found their way into production as embedding provides additional value compared to module or discrete packaging solutions, such as compactness (power density), short lead lengths leading to remarkably low parasitic inductances, good thermal management and significantly improved power cycling capability. These benefits are also seen to be attractive for power applications with high voltages up to 1200 V and specially for fast switching applications > 20 kHz. Nevertheless, some existing blocking points, when looking at how chip embedding is done today, have to be solved first as in the future peak voltages of 1700V, 2000V or even higher are under consideration.

The current chip embedding process does not fulfil high voltage application requirements. The breakdown voltage, ion impurity level (sodium, chlorine, etc.) and the overall reliability of current PCB materials that are used for chip embedding are limited for 650 V (or even below) devices. One of the further problems is also the limited adhesion of polymer layers like prepreg layers and to the core layer of the PCB and possible local delamination of these layers from each other, and in the presence of a device like a semiconductor device also the delamination of the prepreg layers from the semiconductor device.

For these and other reasons there is a need for the present disclosure.

### SUMMARY

A first aspect of the present disclosure is related to an electronic device module comprising a core layer comprising an opening, an electronic device disposed in the opening, one or both of the core layer and the electronic device being at least partially covered by an adhesion promoter layer, and an encapsulant layer at least partially embedding the core layer and the electronic device.

A second aspect of the present disclosure is related to a method for fabricating an electronic device module, the method comprising providing a core layer comprising an opening, providing an electronic device, depositing an adhesion promoter layer at least partially on one or both of the core layer and the electronic device, placing the electronic device in the opening, and at least partially embedding the electronic device and the core layer by an encapsulant layer.

A third aspect of the present disclosure is related to a module comprising a core layer, the core layer being at least partially covered by an adhesion promoter layer, and an encapsulant layer at least partially embedding the core layer.

A forth aspect of the present disclosure is related to a method for fabricating a module, the method comprising providing a core layer, depositing an adhesion promoter layer at least partially on the core layer, embedding at least partially the core layer with an encapsulant layer.

### BRIEF DESCRIPTION OF THE DRAWINGS

The accompanying drawings are included to provide a further understanding of embodiments and are incorporated in and constitute a part of this specification. The drawings illustrate embodiments and together with the description serve to explain principles of embodiments. Other embodiments and many of the intended advantages of embodiments will be readily appreciated as they become better understood by reference to the following detailed description.

The elements of the drawings are not necessarily to scale relative to each other. Like reference numerals designate corresponding similar parts.
Fig. 1 shows an example of an electronic device module according to the first aspect.
Fig. 2 comprises Fig. 2A and 2B and shows cross-sectional side views of a first example of an adhesion promoter layer comprising a single Al₂O₃ layer (A), and a second example of an adhesion promoter layer comprising a layer stack of an Al₂O₃ layer and an AlOOH layer (B).
Fig. 3 shows a flow diagram of a method according to the second aspect for fabricating an electronic device module according to the first aspect.
Fig. 4 comprises Fig. 4A to 4F and shows perspective views and cross-sectional side views for illustrating an example of a method according to the second aspect for fabricating an electronic device module according to the first aspect.

### DESCRIPTION OF EMBODIMENTS

In the following detailed description, reference is made to the accompanying drawings, which form a part hereof, and in which is shown by way of illustration specific embodiments in which the disclosure may be practiced. In this regard, directional terminology, such as "top", "bottom", "front", "back", "leading", "trailing", etc., is used with reference to the orientation of the Figure(s) being described. Because components of embodiments can be positioned in a number of different orientations, the directional terminology is used for purposes of illustration and is in no way limiting. It is to be understood that other embodiments may be utilized and structural or logical changes may be made without departing from the scope of the present disclosure. The following detailed description, therefore, is not to be taken in a limiting sense, and the scope of the present disclosure is defined by the appended claims.

It is to be understood that the features of the various exemplary embodiments described herein may be combined with each other, unless specifically noted otherwise.

As employed in this specification, the terms "bonded", "attached", "connected", "coupled" and/or "electrically connected/electrically coupled" are not meant to mean that the elements or layers must directly be contacted together; intervening elements or layers may be provided between the "bonded", "attached", "connected", "coupled" and/or "electrically connected/electrically coupled" elements, respectively. However, in accordance with the disclosure, the above-mentioned terms may, optionally, also have the specific meaning that the elements or layers are directly contacted together, i.e. that no intervening elements or layers are provided between the "bonded", "attached", "connected", "coupled" and/or "electrically connected/electrically coupled" elements, respectively.

Further, the word "over" used with regard to a part, element or material layer formed or located "over" a surface may be used herein to mean that the part, element or material layer be located (e.g. placed, formed, deposited, etc.) "indirectly on" the implied surface with one or more additional parts, elements or layers being arranged between the implied surface and the part, element or material layer. However, the word "over" used with regard to a part, element or material layer formed or located "over" a surface may, optionally, also have the specific meaning that the part, element or material layer be located (e.g. placed, formed, deposited, etc.) "directly on", e.g. in direct contact with, the implied surface.

### DETAILED DESCRIPTION

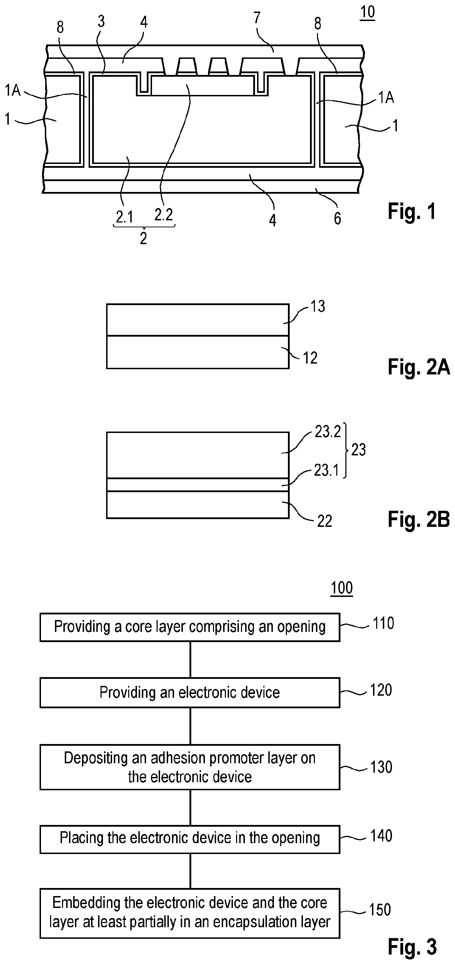

Fig. 1 shows an example of an electronic device module according to the first aspect.

More specifically, Fig. 1 shows an electronic device module 10 comprising a core layer 1 comprising an opening 1A, and an electronic device 2 disposed in the opening. The core layer 1 and the electronic device 2 are embedded in an encapsulant layer 4 such that the core layer 1 and the electronic device 2 are disposed on a lower horizontal layer of the encapsulant layer 4, an upper horizontal layer of the polymer layer 4 is disposed on upper surfaces of the core layer 1 and the electronic device 2, and vertical layers of the encapsulant layer 4 are filled in intermediate spaces between side walls of the core layer 1 and side walls of the electronic device 2 within the opening 1A of the core layer 1.

The core layer 1 can, for example, comprise an FR1, FR2, FR3, or FR4 material, a BT-Epoxy (where BT stands for bismaleimidtriazine), a polyimide, or a cyanate ester. The encapsulant layer 4 may comprise a polymer layer and in particular a prepreg layer 4. A first Cu layer 6 may be disposed on a rear surface of the encapsulant layer 4 remote from the core layer 1. And a second copper layer 7 may be disposed on an upper surface of the upper layer of the encapsulant layer 4, the second copper layer 7 comprising separate electrical areas or traces, the electrical areas connected with electrical vias being connected with contacts pads of the electronic device 2.

The electronic device 2 may in particular comprise a die carrier 2.1, and a semiconductor die 2.2 attached to the die carrier 2.1. The die carrier 2.1 can be a leadframe or any other kind of substrate like a DCB (direct copper bond), an AMB (active metal braze or an IMS (insulated metal substrate). The semiconductor device 2 may also comprise two or more semiconductor dies which may be interconnected to form, e.g., a half bridge, the half bridge being disposed in the opening.

The semiconductor die 2.2 may comprise a semiconductor transistor die 2.2 like, e.g. one or more of an IGBT, a MOSFET die, a CoolMOS, or a wide band gap semiconductor transistor like SiC-MOS, or GaN-MOS. The semiconductor transistor die 2.2 may comprise a contact pad 2.2A on an upper surface thereof, which contact pad 2.2A can be, for example, a source pad 2A.

It should be mentioned that the semiconductor device can also have a completely different structure. While the semiconductor component 2 of Fig. 1 is electrically conductive on its main surfaces, another semiconductor component may also be designed to be partially or completely electrically insulating, in particular on the front and/or rear side the semiconductor component may be designed to be at least partially electrically insulating. In particular, the semiconductor component can be completely embedded in an encapsulant which can be thermally conductive, e.g. in case of a fullpack.

At this point it should be mentioned here that instead of a semiconductor device, another component can also be installed in the module in the manner described. For example, a passive component such as a diode, a capacitor or a resistor can be used. Also a heat sink in the form of a copper insert can be used. A conductor rail or bus bar is also conceivable for use.

The electronic device 2 is covered by an adhesion promoter layer 3 and the core layer 1 may also be covered by a further adhesion promoter layer 8. The adhesion promoter layer 3 and the further adhesion promoter layer 8 can be formed in an identical manner or they can be formed different. In both cases the adhesion promoter layer can be formed by a single e.g. homogeneous layer, e.g. of Al₂O₃, or by a layer stack of e.g. two layers, e.g. of a lower layer of Al₂O₃, and an upper layer e.g. of AlOOH formed by the conversion of Al₂O₃ which will be explained later. The electronic device 2 can be completely or partially covered by the adhesion promoter layer 3 and the core layer 1 can be completely or partially covered by the further adhesion promoter layer 8.

Fig. 2 comprises Fig. 2A and 2B and shows cross-sectional side views of a first example of an adhesion promoter layer comprising a single Al₂O₃ layer (A), and a second example of an adhesion promoter layer comprising a layer stack of an Al₂O₃ layer and an AlOOH layer (B).

Fig. 2A shows a substrate 12 and a single Al₂O₃ layer 13 disposed on the substrate 12. The substrate 12 can be of any kind, depending on the form and structure of the semiconductor device or the core layer used. In case of the example as shown in Fig. 1, the substrate 12 would be a leadframe. On the other hand it could also be the case that the semiconductor device comprises a semiconductor package in which a semiconductor die is fully or almost fully encapsulated by a compound like a molded compound so that the latter would form the substrate 12.

The Al₂O₃ layer 13 can be, for example, deposited by atomic layer deposition (ALD). ALD is a thin-film deposition technique based on the sequential use of a gasphase chemical process. It is a subclass of chemical vapour deposition. The majority of ALD reactions use two chemicals called precursors (also called "reactants"). These precursors react with the surface of a material one at a time in a sequential, self-limiting, manner. The precursors only react with the surface molecules, but not with themselves. A thin and dense layer 13 of Al₂O₃ can in this way be slowly deposited through repeated exposure to separate precursors.

For depositing the Al₂O₃ layer 13 by ALD the applied temperature is typically in a range from 100°C to 350°C. The deposition takes place in cycles in which a precursor A and a precursor B are alternately deposited on the substrate and rinsing with nitrogen takes place in between. One atomic or molecular layer is deposited in each cycle. In the present case of the deposition of Al₂O₃, a layer with a thickness of 20 nm is deposited after 200 cycles. The layer thickness can be in a range from 3 nm to 100 nm.

Fig. 2B shows a substrate 22 and an adhesion promoter layer comprising a layer stack 23 comprising a first layer 23.1 of Al₂O₃ and a second layer 23.2 of AlOOH. The same applies to the substrate 22 as described above for the substrate 12 of Fig. 2A. The first layer 23.1 of Al₂O₃ can be obtained by ALD as was described above in connection with Fig. 2A. Afterwards a following dip into hot deionized water at least partially transfers the dense Al₂O₃ layer into a dendritic AlOOH layer..

Fig. 3 shows a flow diagram of a method according to the second aspect for fabricating an electronic device module according to the first aspect.

More specifically, the method 100 comprises providing a core layer comprising an opening (110), providing an electronic device (120), depositing an adhesion promoter layer on the electronic device (130), placing the electronic device in the opening (140), and at least partially embedding the electronic device and the core layer in an encapsulant layer (150).

According to further examples, as already described in connection with the previous Figures 1 and 2, the method may further comprise one or more of depositing the adhesion promoter layer by atomic layer deposition, the adhesion promoter layer comprising an Al₂O₃ layer either as a single layer or as part of a layer stack together with an AlOOH layer, in particular by depositing the adhesion promoter layer comprising depositing a first layer of Al₂O₃ and converting said first layer partially into a rough AlOOH layer by hydrothermal conversion.

It is also worth mentioning that the individual steps 110 to 150 can also be carried out in a sequence other than that indicated above. In particular, the deposition of the adhesion promoter layer can also take place after the semiconductor device has been placed in the opening, in which case the core layer will inevitably also be covered with the adhesion promoter layer.

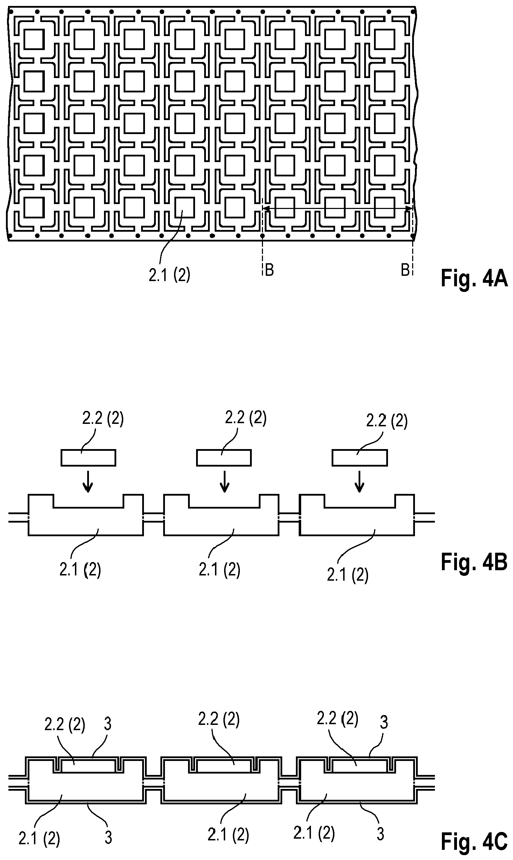

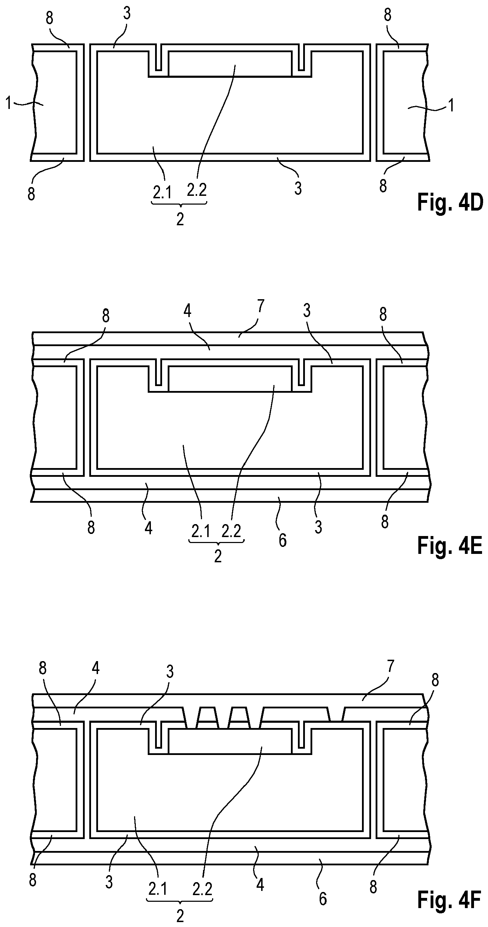

Fig. 4 comprises Fig. 4A to 4G and shows perspective views and cross-sectional side views for illustrating an example of a method according to the second aspect for fabricating an electronic device module according to the first aspect.

Fig. 4A shows a top view on an array of interconnected die carriers, the array comprising a plurality of die carriers connected together in the form of a matrix. Each one of the die carriers may be comprised of a leadframe 2.1 as was shown in Fig. 1. In this Example each one of the leadframes 2.1 is comprised of a piece of metal like copper, the piece of metal comprising an opening in which a semiconductor die is to be disposed.

Fig. 4B shows a cross-sectional view through a portion of the leadframe array, the portion indicated by line B-B in Fig. 2A. Fig. 4B illustrates the insertion of semiconductor dies 2.2 into the openings of the leadframes 2.1. In this Example single semiconductor dies 2.2 are inserted into the openings of the leadframes 2.1. It is however also possible to dispose more complex arrangements of semiconductor dies in the openings like, for example, half bridges of two interconnected semiconductor dies. The semiconductor dies 2.1 can be fixed to the bottom of the openings by a soldering process.

Fig. 4C shows the semiconductor devices 2 after coating with an adhesion promoter layer 3, in particular in the form of an Al₂O₃ layer 3.

In this way, an Al₂O₃ layer 3 can be produced as shown in Fig. 2A. If desired, a layer stack consisting of a lower Al₂O₃ layer and an upper AlOOH layer, as shown in Fig. 2B, can be produced from this by dipping the leadframe array with the Al₂O₃ layer into a bath of hot deionized water, as was already described above.

Afterwards the leadframe array of interconnected semiconductor devices 2 is singulated into a plurality of individual semiconductor devices 2 each one of which being covered with an adhesion promoter layer 3.

Fig. 4D shows one of the semiconductor devices 2 after inserting it into an opening 1A of a core layer 1. In the present Example the core layer 1 comprises an FR4 material. However, also other materials like FR1, FR2, FR3, or, a BT-epoxy (where BT stands for bismaleimidtriazine), a polyimide, a cyanate ester, glass, ceramic (AlO, SiN), and also electrically conductive materials, are conceivable as materials of the core layer 1. In the present Example the core layer 1 is covered by a further adhesion promoter layer 8 which may be produced in the same way as the adhesion promoter layer 3 of the semiconductor device 2. The adhesion promoter layer 8 of the core layer 1 can thus also have either a singular layer of Al₂O₃ or a layer stack consisting of a lower Al₂O₃ layer and an upper AlOOH layer.

Fig. 4E shows the semiconductor device 2 of Fig. 4D after applying prepreg layers 4 and 5 on upper and lower surfaces of the semiconductor device 2 and the core layer 1. Each one of the prepreg layers 4 and 5 comprises a copper layer 6 and 7 on an outer surface thereof, respectively. In a subsequent lamination process the prepreg layers 4 and 5 and the core layer 1 are pressed together and material of the prepreg layers 4 and 5 is flowing into intermediate spaces between the semiconductor device 2 and inner walls of the opening 1A so that upper and lower prepreg layers 4 and 5 are connected with each other.

Fig. 4F shows the semiconductor device module after drilling vias into the upper copper layer 7 and the upper portion of the laminated prepreg layer 4, part of the vias reaching down to the contact pads of the semiconductor die 2.2 and to the leadframe 2.1. For example, one of the vias extends down to the source pad, another one down to the gate pad, another one down to the source sense pad, if present, and another one down to the leadframe 2.1 which is electrically connected with the drain pad of the semiconductor die 2.2, the drain pad being located on a lower main face of the semiconductor die 2.2. Each one of the vias is then filled with copper by chemical galvanic plating and connected with an area or trace of the upper copper layer 7.

According to the third and fourth aspects, the present disclosure is also related to a module and a method for fabricating the same, the module comprising a core layer, an adhesion promoter layer covering the core layer and an encapsulant layer embedding the core layer. This means in other words, the use of an adhesion promoter layer in, for example, a PCB or other substrates, independent of the implementation of electrical or electronic components in the PCB. The same properties and features of the individual components as well as of the manufacturing processes as described above in connection with the first and second aspects can be used.

### EXAMPLES

In the following specific examples of the present disclosure are described.

Example 1 is an electronic device module, comprising a core layer comprising an opening, an electronic device disposed in the opening, one or both of the core layer and the electronic device being at least partially covered by an adhesion promoter layer, and an encapsulant layer embedding the core layer and the electronic device.

Example 2 is the semiconductor package according to Example 1, wherein the adhesion promoter layer comprises an Al₂O₃ layer.

Example 3 is the semiconductor package according to Example 1 or 2, wherein the adhesion promoter layer comprises a first layer of Al₂O₃ and a second layer of AlOOH disposed on the first layer.

Example 4 is the semiconductor package according to any one of the preceding Examples, wherein the core layer is covered by a further adhesion promoter layer.

Example 5 is a method for fabricating an electronic device module, the method comprising providing a core layer comprising an opening, providing an electronic device, depositing an adhesion promoter layer at least partially on one or both of the core layer and the electronic device, placing the electronic device in the opening, and embedding the electronic device and the core layer at least partially by an encapsulant layer.

Example 6 is the method according to Example 5, wherein the electronic device is placed in the opening and thereafter the adhesion promoter layer is deposited at least partially on both the core layer and the electronic device.

Example 7 is the method according to Example 5 or 6, further comprising depositing the first adhesion promoter layer by atomic layer deposition.

Example 8 is the method according to any one of Examples 5 to 7, wherein the adhesion promoter layer comprises an Al₂O₃ layer.

Example 9 is the method according to any one of Examples 5 to 8, wherein depositing the adhesion promoter layer comprises depositing a first layer of Al₂O₃ and depositing a second layer of AlOOH on the first layer.

Example 10 is the method according to any one of Examples 5 to 9, wherein the core layer is covered by a further adhesion promoter layer.

Example 11 is a device module, comprising a core layer, the core layer being at least partially covered by an adhesion promoter layer, and an encapsulant layer embedding the core layer.

Example 12 is the semiconductor package according to Example 11, wherein the adhesion promoter layer comprises an Al₂O₃ layer.

Example 13 is the semiconductor package according to Example 11 or 12, wherein the adhesion promoter layer comprises a first layer of Al₂O₃ and a second layer of AlOOH disposed on the first layer.

Example 14 is the device module according to any one of Examples 11 to 13, further comprising the core layer comprising an opening, and an electronic device disposed in the opening.

Example 15 is a method for fabricating a device module, the method comprising providing a core layer, depositing an adhesion promoter layer at least partially on the core layer, embedding the core layer in an encapsulant layer.

Example 16 is the method according to Example 15, further comprising depositing the first adhesion promoter layer by atomic layer deposition.

Example 17 is the method according to Example 15 or 16, wherein the adhesion promoter layer comprises an Al₂O₃ layer.

Example 18 is the method according to any one of Examples 15 to 17, wherein depositing the adhesion promoter layer comprises depositing a first layer of Al₂O₃ and depositing a second layer of AlOOH on the first layer.

Example 19 is the semiconductor package according any one of Examples 15 to 18, further comprising the core layer comprising an opening, and disposing an electronic device in the opening.

In addition, while a particular feature or aspect of an embodiment of the disclosure may have been disclosed with respect to only one of several implementations, such feature or aspect may be combined with one or more other features or aspects of the other implementations as may be desired and advantageous for any given or particular application. Furthermore, to the extent that the terms "include", "have", "with", or other variants thereof are used in either the detailed description or the claims, such terms are intended to be inclusive in a manner similar to the term "comprise". Furthermore, it should be understood that embodiments of the disclosure may be implemented in discrete circuits, partially integrated circuits or fully integrated circuits or programming means. Also, the term "exemplary" is merely meant as an example, rather than the best or optimal. It is also to be appreciated that features and/or elements depicted herein are illustrated with particular dimensions relative to one another for purposes of simplicity and ease of understanding, and that actual dimensions may differ substantially from that illustrated herein.

Although specific embodiments have been illustrated and described herein, it will be appreciated by those of ordinary skill in the art that a variety of alternate and/or equivalent implementations may be substituted for the specific embodiments shown and described without departing from the scope of the present disclosure. This application is intended to cover any adaptations or variations of the specific embodiments discussed herein. Therefore, it is intended that this disclosure be limited only by the claims and the equivalents thereof.

## Claims

1. An electronic device module (10), comprising
a core layer (1) comprising an opening (1A);
an electronic device (2) disposed in the opening (1A), one or both of the core layer (1) and the electronic device (2) being at least partially covered by an adhesion promoter layer (3); and
an encapsulant layer (4) embedding the core layer (1) and the electronic device (2).

2. The electronic device module (10) according to claim 1, wherein
the adhesion promoter layer (3) comprises an Al₂O₃ layer.

3. The electronic device module (10) according to claim 1 or 2, wherein
the adhesion promoter layer (3) comprises a first layer of Al₂O₃ and a second layer of AlOOH disposed on the first layer.

4. The electronic device module (10) according to any one of the preceding claims, wherein
the core layer (1) is covered by a further adhesion promoter layer.

5. A method (100) for fabricating an electronic device module, the method comprising
- providing a core layer comprising an opening (110);
- providing an electronic device (120);
- depositing an adhesion promoter layer at least partially on one or both of the core layer and the electronic device (130) ;
- placing the electronic device in the opening (140); and
- embedding the electronic device and the core layer at least partially by an encapsulant layer (150).

6. The method according to claim 5, wherein
the electronic device is placed in the opening and thereafter the adhesion promoter layer is deposited at least partially on both the core layer and the electronic device.

7. The method according to claim 5 or 6, further comprising depositing the first adhesion promoter layer by atomic layer deposition.

8. The method according to any one of claims 5 to 7, wherein the adhesion promoter layer (3) comprises an Al₂O₃ layer.

9. The method according to any one of claims 5 to 8, wherein depositing the adhesion promoter layer comprises depositing a first layer of Al₂O₃ and depositing a second layer of AlOOH on the first layer.

10. The method according to any one of claims 5 to 9, wherein the core layer (1) is covered by a further adhesion promoter layer.

11. A device module, comprising
a core layer, the core layer being at least partially covered by an adhesion promoter layer; and
an encapsulant layer embedding the core layer.

12. The device module according to claim 11, wherein
the adhesion promoter layer (3) comprises an Al₂O₃ layer.

13. The device module according to claim 11 or 12, wherein the adhesion promoter layer comprises a first layer of Al₂O₃ and a second layer of AlOOH disposed on the first layer.

14. The device module according to any one of claims 11 to 13, further comprising
the core layer comprising an opening; and
an electronic device disposed in the opening.

15. A method for fabricating a device module, the method comprising
- providing a core layer;
- depositing an adhesion promoter layer at least partially on the core layer;
- embedding the core layer in an encapsulant layer.

16. The method according to claim 15, further comprising depositing the first adhesion promoter layer by atomic layer deposition.

17. The method according to claim 15 or 16, wherein
the adhesion promoter layer comprises an Al₂O₃ layer.

18. The method according to any one of claims 15 to 17,
wherein
depositing the adhesion promoter layer comprises depositing a first layer of Al₂O₃ and depositing a second layer of AlOOH on the first layer.

19. The method according to any one of claims 15 to 18, further comprising
the core layer comprising an opening; and
disposing an electronic device in the opening.
